# EUROPEAN PATENT APPLICATION

(11) **EP 4 765 192 A1**
(43) Date of publication of application: **24.06.2026**
(21) Application number: 24307163.6
(22) Date of filing: 18.12.2024
(51) Int. Cl.: H01L 21/20, H10D 62/85, H10D 30/01, H10D 30/47

(54) **LAYERED SEMICONDUCTOR STRUCTURES AND METHODS FOR FABRICATING LAYERED SEMICONDUCTOR STRUCTURES**

(71) Applicant: Nokia Networks France, 91300 Massy (FR)
(72) Inventor: DECOBERT, Jean, 91620 Nozay (FR); BESANCON, Claire, 75014 Paris (FR)
(74) Representative: Novagraaf Technologies

(57) **Abstract**

A layered semiconductor structure comprises: an InP on Silicon, InPoSi, substrate. The InPoSi substrate comprises: a silicon substrate; a silica layer on the silicon substrate; and an InP seed layer on the silica layer; a stack of III-V layers on the InPoSi substrate. The stack of III-V layers comprises a buffer layer above the InP seed layer. The buffer layer is made of In_{y}Al_{1-y}As, y being smaller than or equal to 0.53.

## Description

### TECHNICAL FIELD

Examples of the present disclosure relate to layered semiconductor structures and layered semiconductor structure fabrication methods.

### BACKGROUND

InP on silicon (InPoSi) semiconductor technology utilises InP on a silicon substrate to allow for the integration of InP-based devices on the silicon platform. However, there are challenges combining such technologies in order to exploit the beneficial characteristics of both InP and the silicon substrate.

An objective of the present disclosure is to address such challenges, amongst others.

### SUMMARY

According to some aspects, there is provided the subject matter of the independent claims. Some further aspects are defined in the dependent claims.

The embodiments, examples and features, if any, described in this specification that do not fall under the scope of protection defined by the claims, are to be interpreted as examples useful for understanding the various embodiments or examples that fall under the scope of protection.

According to a first exemplary aspect, there is provided a layered semiconductor structure comprising: an InP on Silicon, InPoSi, substrate, wherein the InPoSi substrate comprises: a silicon substrate; a silica layer on the silicon substrate; and an InP seed layer on the silica layer. The layered semiconductor structure further comprises: a stack of III-V layers on the InPoSi substrate, wherein the stack of III-V layers comprises a buffer layer above the InP seed layer; wherein the buffer layer is made of In_{y}Al_{1-y}As, y being smaller than or equal to 0.53.

In example embodiments, y may be larger than 0.47.

In example embodiments, the buffer layer may have a thickness smaller than or equal to 500 nm.

In example embodiments, the buffer layer may be a grown layer on the InP seed layer.

In example embodiments, the InP seed layer may be a bonded layer on the silica layer.

In example embodiments, the layered semiconductor structure may comprise two superimposed buffer layers in contact with each other, the lower of the two superimposed buffer layers being the buffer layer on the InP seed layer, wherein the upper of the buffer layers is thinner than the lower buffer layer and has a thickness smaller than 50 nm, wherein the upper buffer layer is made of In_{z}Al_{1-z}As, z being smaller than or equal to 0.53 and larger than 0.47, wherein z is smaller than y.

In example embodiments, the stack of III-V layers may comprise: at least one channel layer above the at least one buffer layer, wherein the at least one channel layer is made of InₓGa₁₋ₓAs, wherein x is larger than or equal to 0.53.

In example embodiments, the stack of III-V layers may comprise: a spacer layer made of InₛAl₁₋ₛAs, wherein the spacer layer is next to at least one channel layer; and a barrier layer made of In_{b}Al_{1-b}As, wherein the barrier layer is above the spacer layer.

In example embodiments, the stack of III-V layers may comprise at least one n-type delta doped interface layer between the spacer layer and the barrier layer.

In example embodiments, b may be smaller than or equal to 0.53, and b may be larger than 0.47.

In example embodiments, s may be smaller than or equal to 0.53, and s may be larger than 0.47.

In example embodiments, the channel layer(s) may have a thickness smaller than or equal to 30 nm.

In example embodiments, the spacer layer may have a thickness smaller than or equal to 10 nm.

In example embodiments, the barrier layer may have a thickness smaller than or equal to 40 nm.

According to another exemplary aspect, there is provided a photonic structure comprising a least one layered semiconductor structure according to the first exemplary aspect.

According to another exemplary aspect, there is provided a high electron mobility transistor, HEMT, structure comprising at least one layered semiconductor structure according to the first exemplary aspect.

In example embodiments, the HEMT structure may comprise a source comprising a first InGaAs region above the stack of III-V layers; a drain comprising a second InGaAs region above the stack of III-V layers; a gate positioned above the stack of III-V layers, between the first and second InGaAs regions and electrically isolated from the first and second InGaAs regions.

According to another exemplary aspect, there is provided a method for fabricating a layered semiconductor structure, the method comprising: providing an InP on Silicon, InPoSi, substrate comprising a silicon substrate, a silica layer on the silicon substrate and an InP seed layer on the silica layer; depositing by epitaxy a stack of III-V layers including a buffer layer above the InP seed layer; wherein the buffer layer is made of In_{y}Al_{1-y}As, y being smaller than or equal to 0.53.

### BRIEF DESCRIPTION OF THE DRAWINGS

Some example embodiments will now be described with reference to the accompanying drawings. These drawings are intended to illustrate various aspects of devices, methods and structures used in example embodiments described herein.
FIG. 1 is a schematic cross-sectional diagram of a layered semiconductor structure according to an example.
FIG. 2 is a schematic cross-sectional diagram of a layered semiconductor structure according to an example.
FIG. 3 is a schematic cross-sectional diagram of a layered semiconductor structure according to an example.
FIG. 4 is a schematic cross-sectional diagram of a layered semiconductor structure according to an example.
FIG. 5 is a schematic cross-sectional diagram of a layered semiconductor structure according to an example.
FIG. 6 is a schematic cross-sectional diagram of a layered semiconductor structure according to an example.
FIG. 7 is a schematic cross-sectional diagram of a HEMT including a layered semiconductor structure according to an example.
FIG. 8 is a flow chart of a method for fabricating a layered semiconductor structure.

The use of similar or identical reference numbers in the various drawings is intended to indicate the presence of a similar or identical element or feature.

### DETAILED DESCRIPTION

Detailed example embodiments are disclosed herein. The example embodiments are given by way of illustration only and thus are not limiting of this disclosure. These example embodiments may be embodied in many alternate forms, with various modifications, and should not be construed as limited to only the embodiments set forth herein. In addition, the figures and descriptions may have been simplified to illustrate elements and / or aspects that are relevant for a clear understanding of the present invention, while eliminating, for purposes of clarity, many other elements that may be well known in the art or not relevant for the understanding of the invention.

An InP layer can be arranged on a silicon substrate with a silica layer to fabricate an InPoSi substrate, also referred to herein as "InPoSi wafer". Typically, bonding (e.g., hydrophilic direct bonding) is used to bond the InP to the silica layer on the silicon substrate of the InPoSi wafer. Further layers (for example, III-V layers, and others) can then be grown onto the InP layer to form device structures.

However, because InP has a lower thermal expansion coefficient than silicon, the InP layer of the InPoSi wafer is compressively strained at elevated temperatures (e.g., temperatures are between 400 and 700 Celsius degrees) during III-V material growth (e.g., epitaxial growth) on the InPoSi substrate. This makes the growth on InPoSi more constraint as compared for example to a growth on an InP substrate.

The present disclosure provides a layered semiconductor structure, and method of fabrication thereof that can obviate such issues.

A layered semiconductor structure with an InPoSi substrate is disclosed. The InPoSi substrate comprises: a silicon substrate; a silica layer on (e.g., in contact with) the silicon substrate; and an InP seed layer on (e.g., in contact with) the silica layer.

A stack of III-V layers is arranged on the InPoSi substrate. The stack of III-V layers comprises a buffer layer above or on (e.g., in contact with) the InP seed layer. The buffer layer is made of In_{y}Al_{1-y}As, y being smaller than or (substantially) equal to 0.53.

By using a buffer layer made of In_{y}Al_{1-y}As, with y being smaller than or (substantially) equal to 0.53, a compromise can be found. For a value of y close or (substantially) equal to 0.53, a lattice-matched buffer layer is achieved while for smaller values of y, a tensile strained buffer layer is achieved. With such a composition of the buffer layer, it is possible, at elevated temperature during epitaxial growth, to deposit a lattice matched buffer layer to the InPoSi substrate and compensate the compressive strain inherent to the InPoSi substrate.

Further advantages will become apparent from the below detailed description of the drawings.

As used herein, a first layer is said to be "on" or "in contact with" a second layer when the first layer is arranged directly on the second layer, i.e., with no further layers separating the first and second layers. In contrast, when a first layer is said to be "above" a second layer, the first layer may be in contact with the second layer or there may be one or more further layers separating the first and second layers.

The term "substantially" used herein for a property (e.g., a value of a parameter) is to be interpreted as a way to indicate potential variations of the property (e.g., around the specified parameter value) due to tolerances applicable in the technical domain, e.g., fabrication tolerances in a method used to manufacture the concerned semiconductor structure.

The subscript y (and likewise z, s, b, x) used herein in the chemical composition of an alloy indicates a respective contribution of a material in atomic percentage over the total number of atoms in the alloy. In an example, In_{0.53}Al_{0.47}As means that for 100 atoms of As (Arsenic), there will be substantially 53 atoms of In (Indium) and 47 atoms of Al (Aluminium). Of course, due to fabrication tolerances, the real percentage may vary slightly around the exact value of the percentage.

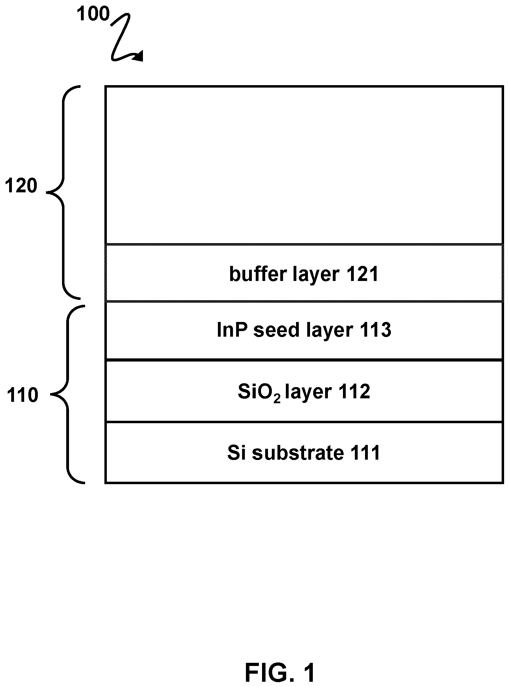

FIG. 1 is a schematic cross-sectional diagram of a first layered semiconductor structure 100 according to an example.

The first layered semiconductor structure 100 comprises an InPoSi substrate 110. The InPoSi substrate 110 comprises: a silicon substrate 111; a silica layer (SiOz layer) 112 on (e.g., in contact with) the silicon substrate; and an InP seed layer 113 above the silica layer 112. The InPoSi substrate may be a 300 mm large wafer.

In other embodiments (not shown on the figures), extra layers can be present in the InPoSi substrate. For example, due to small manufacturing variations, some extra small layers may however be present. For example, there may be a SiN layer between the SiO2 layer and the InP layer.

For fabrication of the InPoSi substrate of the layered semiconductor structure 100, the InP seed layer may be bonded (e.g., by hydrophilic direct bonding) on the silica layer. A thin "bonding" transition layer between the InP seed layer and the silica layer is formed by the bonding process.

A stack 120 of III-V layers is arranged on the InPoSi substrate. The stack 120 of III-V layers comprises, as bottom layer, a buffer layer 121 above or on (e.g., in contact with) the InP seed layer. The stack 120 of III-V layers may comprise one or more III-V layers above or on the buffer layer 121. For the other layers of the III-V stack 120 above the buffer layer 121, any alloy (including e.g., binary, ternary, quaternary and quinary alloys) from the Al, Ga, In, As, P family may be used.

The buffer layer 121 is made of In_{y}Al_{1-y}As, y being smaller than or (substantially) equal to 0.53. The InP-based layer 113 can be considered as a template layer used for regrowth of the stack 120 of III-V layers.

For fabrication of the layered semiconductor structure 100, the buffer layer 121 and all layers in the stack 120 of III-V layers may be grown (e.g., by epitaxial growth) above or on the InP seed layer of the InPoSi substrate. In embodiments, there may be a second InP layer deposited on the InP seed layer of the InPoSi substrate.

The buffer layer may have a thickness smaller than or (substantially) equal to 500 nm. The buffer layer may have a much lower thickness, (e.g., up to 100 nm) without incidence on the behaviour of the device in which the layered semiconductor structure is integrated.

As an example, the buffer layer 121 may be made of In_{0,52}Al_{0,48}As As and be 500 nm thick. As another example, the buffer layer 121 may be made of In_{0,495}Al_{0,505}As and be 100 nm thick. The buffer layer 121 may have a thickness between 100 and 500 nm. The thickness may be adapted to the value of y.

The approach described with reference to FIG. 1 allows to compensate the compressive thermal strain induced at growth temperature on the InP seed layer 113 by the silicon substrate 111 through the use of a specific composition of the buffer layer. This allows for strain-free epitaxy on InPoSi at growth temperature. This mitigates the adverse effects induced by the compressive thermal strain. Therefore, a III-V device of improved quality can be built based on the InPoSi substrate thanks to the improved buffer properties.

The thickness of the buffer layer may be adapted when the value y is decreased in the In_{y}Al_{1-y}As buffer layer (y<0.53): the strain increases when y decreases and a lower thickness allows to avoid layer relaxation or degradation of the buffer layer.

The layered semiconductor structure 100 with an InPoSi substrate disclosed herein is adapted for fabricating an opto- or micro-electronic III-V based device or a HEMT.

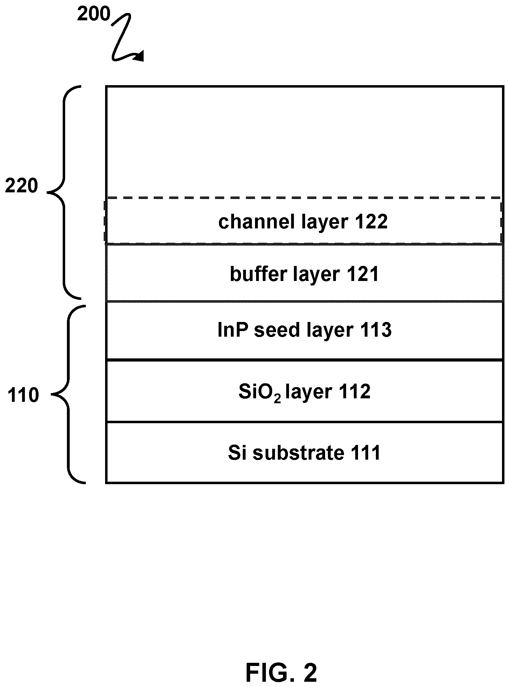

FIG. 2 is a schematic cross-sectional diagram of a layered semiconductor structure 200 according to an example.

In the example of FIG. 2, the layered semiconductor structure 200 includes an InPoSi substrate 110, that may be similar or identical to the InPoSi substrate 110 of the layered semiconductor structure of FIG. 1. The layered semiconductor structure 200 includes a stack 120 of III-V layers arranged on the InPoSi substrate that may be similar or identical to the stack 120 of FIG. 1. The layered semiconductor structure 200 includes a buffer layer 121 that may be similar or identical to the buffer layer 121 of the layered semiconductor structure of FIG. 1. Like for FIG. 1, the buffer layer 121 is above or on (e.g., in contact with) the InP seed layer of the InPoSi substrate 110.

A difference with respect to the layered semiconductor structure of FIG. 2 relies in the presence of a channel layer 122 above the buffer layer 121. The stack 220 of III-V layers may comprise, on the buffer layer 121, one or more one channel layers, only one channel layer being represented.

The channel layer provides a region adapted for electron circulation with a material offering high mobility for electrons and low resistivity. The buffer layer 121 is used to electrically isolate the channel layer 122 from the substrate, e.g., by confining the electrons in the channel.

The channel layer 122 may be made of InₓGa₁₋ₓAs, where x is larger than or (substantially) equal to 0.53 for each channel layer. It is to be noted that in embodiments with several channel layers, the value x may be different for each channel layer. For example, with two channel layers, the value x may be smaller for the lower channel layer and be larger for the upper channel layer.

Also, the layered semiconductor structure 100 allows to fabricate a HEMT with high performance, where the HEMT comprises, on (e.g., in contact with) the buffer layer, a channel layer made of InGaAs, providing high mobility to the electrons in the channel layer.

The layered semiconductor structure according to FIG. 2 solves several constraints at the same time: the specific composition of the buffer layer solves the strain issue of InPoSi substrate as explained above for FIG. 1 and, at the same time, solves the strain limitation of the channel layer made of InGaAs material which is rich in Indium (e.g., with x>0.53 or even higher) and provides a channel with high mobility for the electrons. The higher Indium content in the channel layer, the higher the electron mobility in the channel layer, the better for the low noise factor and the HEMT performance. For example, with a channel layer made of InAs (InₓGa₁₋ₓAs with x=1), the highest mobility can be achieved. The strain of the channel layer can also better be compensated with an InPoSi substrate (by the used the specific composition of the buffer layer) as compared to an InP substrate.

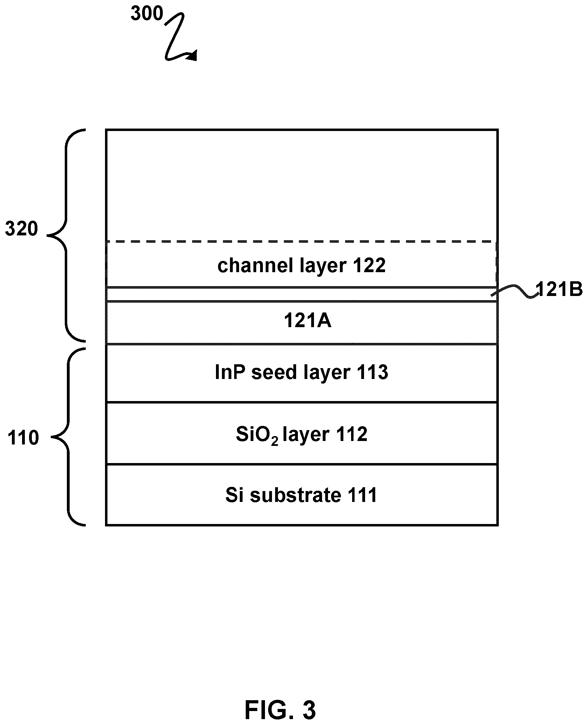

FIG. 3 is a schematic cross-sectional diagram of a second layered semiconductor structure 300 according to an example with two superimposed buffer layers in a III-V stack 320.

In the example of FIG. 3, the layered semiconductor structure 300 includes an InPoSi substrate 110, that may be similar or identical to the InPoSi substrate of the layered semiconductor structure of FIG. 1 or 2. The layered semiconductor structure 300 includes a buffer layer 121 that may be similar or identical to the buffer layer 121 of the layered semiconductor structure of FIG. 1 or 2.

A difference with respect to the layered semiconductor structure 200 of FIG. 2 relies in the presence of comprises two superimposed buffer layers 121A and 121B in contact with each other to form a buffer between the channel 122 and InPoSi substrate 110. The two superimposed buffer layers 121A and 121B replace the single buffer layer 121 of FIG. 1 or 2.

The lower buffer layer 121A is on (e.g., in contact with) the InP seed layer. The lower buffer layer 121A is made of In_{y}Al_{1y}As, y being smaller than or (substantially) equal to 0.53 and larger than 0.47.

The upper buffer layer 121B is on (e.g., in contact with) the lower buffer layer 121A. The upper buffer layer 121B is made of In_{z}Al_{1z}As, z being smaller than or (substantially) equal to 0.53 and larger than 0.47, where z is smaller than y.

The upper buffer layer 121B may be thinner than the lower buffer layer 121A. For example, the lower buffer layer 121A may have a thickness (substantially) equal to or smaller than 300 nm and the upper buffer layer 121B may have thickness (substantially) equal to or smaller than to 50 nm.

The upper buffer layer 121B may for example be made of In_{0.48}Al_{0.52}As with a 20 nm thickness. The lower buffer layer 121A may for example be made of In_{0.49}Al_{0.51}As with a 350 nm thickness.

The lower buffer layer 121A allows to have a better lattice matching with respect to the InP seed layer and compensation of the coefficient of the thermal expansion while relaxing the lattice matching constraint for the upper buffer layer 121B to provide better electron confinement in the channel layer and to compensate for strain in the channel layer.

The use of two (or more) superimposed buffer layers for forming a buffer between the channel 122 and InPoSi substrate 110 allows to adjust the thicknesses and compositions of each buffer layer. With only one buffer layer, the buffer layer may be thicker but then may break more easily. With a buffer made of two (or more) buffer layers, the constraint adjustment problem on the InPoSi substrate side and on the channel side can be dealt with rather independently, at least in two stages, by fitting the composition of the lower buffer to the InPoSi substrate and by fitting the composition of the upper buffer layer to the channel layer.

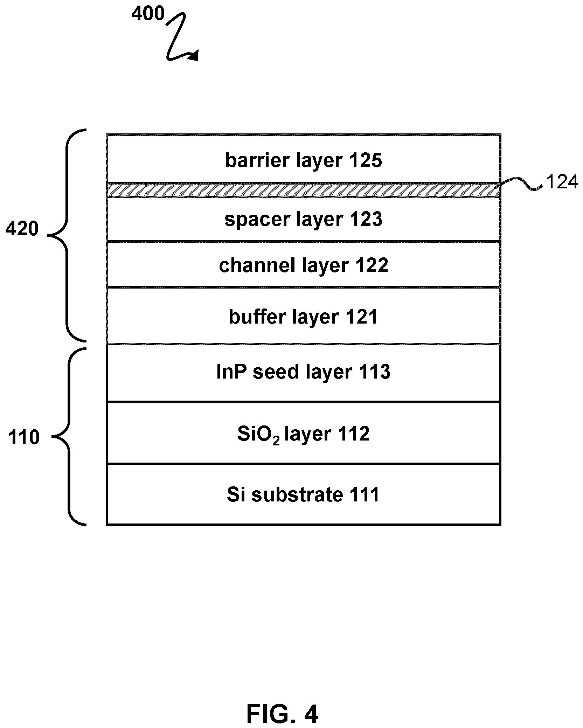

FIG. 4 is a schematic cross-sectional diagram of a layered semiconductor structure 400 according to an example with a channel layer suitable for a HEMT.

In the example of FIG. 4, the layered semiconductor structure 400 includes an InPoSi substrate 110, that may be similar or identical to the InPoSi substrate described by reference to any of FIGS. 1 to 3.

The layered semiconductor structure 400 further includes a stack 420 of III-V layers that includes a channel layer 122, that may be similar or identical to the channel layer described by reference to any of FIGS. 2 to 3.

The stack 420 of III-V layers may further comprise a spacer layer 123, made of InₛAl₁₋ₛAs. The spacer layer 123 is next to the channel layer 122: there may be a spacer layer 123 above and/or below, but in contact with, the at least one channel layer 122.

The value of s may be smaller than or (substantially) equal to 0.53 and larger than 0.47. For example, s is substantially equal to 0.52. As for the InP buffer layer, this allows to compensate for strain induced during the growth of the stack 420 of III-V layers.

The stack 420 of III-V layers may further comprise a barrier layer 125 made of In_{b}Al_{1-b}As, wherein the barrier layer 125 is above or on (e.g., in contact with) the spacer layer 123.

The value of b may be smaller than or (substantially) equal to 0.53 and larger than 0.47. As for the InP buffer layer, this allows to compensate for strain induced during the growth of the stack 420 of III-V layers. For example, b is substantially equal to 0.52.

The thicknesses of the barrier and spacer layers may be selected for optimal electrical behaviour of the HEMT incorporating the layered semiconductor structure 400. The energy bands in the device create a two-dimensional electron gas in the HEMT. Generally, the order of magnitude of the thicknesses is the same for the barrier and spacer layers and the channel layers.

Each channel layer may have a thickness smaller than or (substantially) equal to 30 nm. For example, the channel layer 122 can be substantially 10 nm thick.

The barrier layer 125 may have a thickness smaller than or (substantially) equal to 40 nm. For example, the barrier layer 125 can be substantially 15 nm thick.

The spacer layer 123 may have a thickness smaller than or (substantially) equal to 10 nm. For example, the spacer layer 123 can be substantially 5 nm thick.

Also varying the barrier and spacer composition changes their bandgap, which may affect (positively or not) the HEMT behavior. The bandgap of a layer increases as y or b or s decreases. The increase of the bandgap in the barrier and spacer layers allows to increase the confinement of electrons in the channel layer.

Optionally, the stack 420 of III-V layers may comprise at least one n-type delta doped interface layer 124 between the spacer layer and the barrier layer.

The n-type delta doped interface layer 124 is a layer in which impurities have been added, thereby forming an electron reservoir. During the use of the layered semiconductor structure in a HEMT, a lot of electrons can be transferred from this n-type delta doped interface layer 124 into the channel layer 122 to increase the number of electrons in the channel layer 122 and thereby increases the current that may pass through the HEMT.

The n-type delta doped interface layer 124 may have a thickness smaller than or (substantially) equal to 1 nm.

The higher the value of x (the more Indium in the channel layer), the higher the mobility of the electron in the channel layer. But at the same time, the higher the value of x, the more constrained is the material of the channel layer. And the quality of a stressed material can deteriorate.

The principles discussed for the composition of the buffer layer(s) also apply to the composition of the barrier layer and spacer layer.

The materials of the barrier layer and spacer layer, made of InAIAs can be realized with an indium percentage such that b is smaller than or (substantially) equal to 0.53 and larger than 0.47. This allows to use an even more stressed InGaAs channel with a high value of x.

The layered semiconductor structures disclosed herein can be used for effective III-V based HEMT devices, even on large InPoSi wafers (for example 300 mm large wafers). They allow to compensate for the CTE difference and at the same time compensate for the channel strain by tuning the composition of the InAIAs buffer layer.

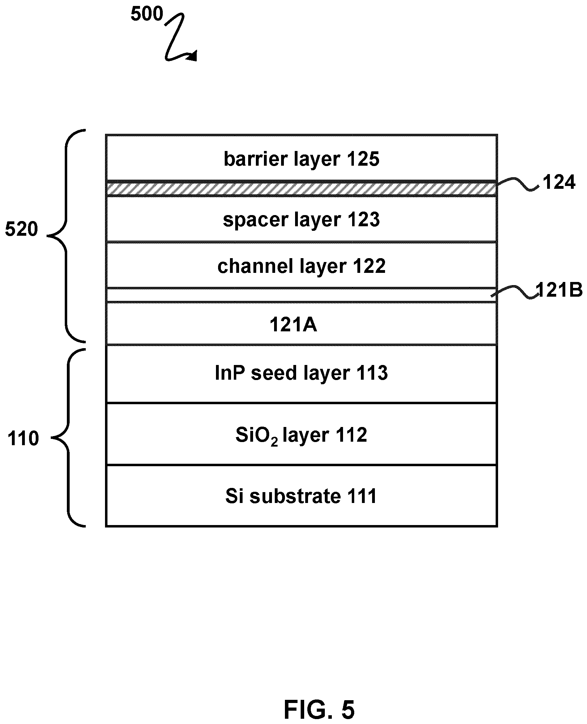

FIG. 5 is a schematic cross-sectional diagram of a layered semiconductor 500 structure according to an example.

In the example of FIG. 5, the layered semiconductor structure 500 includes an InPoSi substrate 110, that may be similar or identical to the InPoSi substrate of the layered semiconductor structure disclosed with reference to FIGS. 1 to 3.

The layered semiconductor structure 500 further includes a stack 520 of III-V layers, similar to the stack 420 of FIG. 4, except that the stack 520 of III-V layers includes two buffer layers 121A and 121B instead of a single buffer layer 121. The two buffer layers 121A and 121B may be similar or identical to those of FIG. 3.

The layered semiconductor structures 500 described with reference to FIGS. 1 to 5 are adapted to be integrated in a micro- or opto-electronic device or a HEMT.

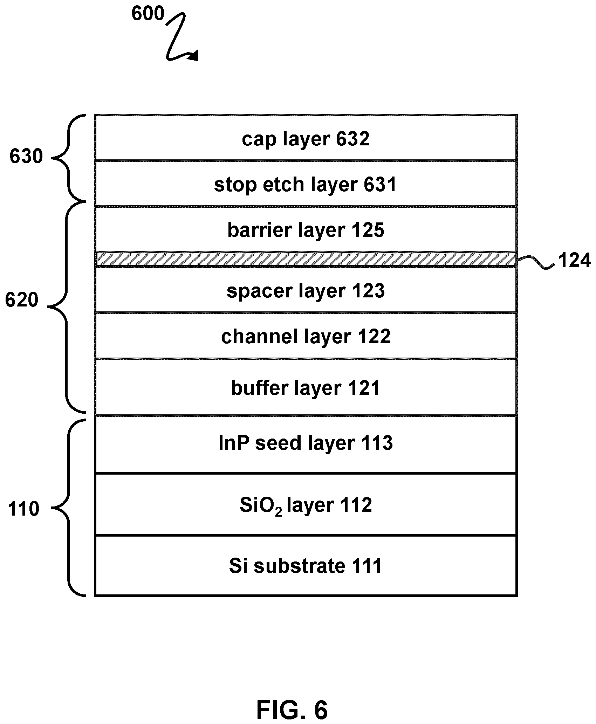

FIG. 6 is a schematic cross-sectional diagram of a layered semiconductor structure 600 according to an example.

This layered semiconductor structure 600 can be used as a base structure for a HEMT.

This layered semiconductor structure 600 comprises: an InPoSi substrate 110, a III-V stack 620; and a cap layer 632, adapted for depositing metallic contacts of the source, drain and gate of the HEMT.

The InPoSi substrate 110 can be substantially the same as the InPoSi substrate described herein, for example with reference to FIGS. 1 to 3, and the description will not be repeated for the sake of brevity. The III-V stack 620 can be substantially the same as the III-V stack 420 of FIG. 4 with only one buffer layer. Alternatively, the III-V stack 620 may be substantially the same as the III-V stack 520 of FIG. 5 with two (or more) superimposed buffer layers.

The cap layer 632 may be made of In_{c}Ga_{1-c}As, where c is (substantially) equal to 0.53. The semiconductor used for the cap layer allows good metallic contact with the source or drain or the HEMT.

Optionally, the layered semiconductor structure 600 may include a stop etch layer 631 made of InP, for example between the III-V stack 620 and the cap layer 632. The need for a stop etch layer 631 depends on the chosen fabrication process and may be used for better control of the etching process used to etch the cap layer 632 when forming the electric contacts of the HEMT from the layered semiconductor structure 600.

To be able to etch correctly, stopping exactly where necessary, a chemical solution may be used that only etches InP and stop at the InAIAs barrier layer. The stop etch layer allows to make it easier to selectively etch the layers and engrave the gate so that the gate can be fitted more easily, such that the gate is placed right on the barrier and is as close as possible to the channel.

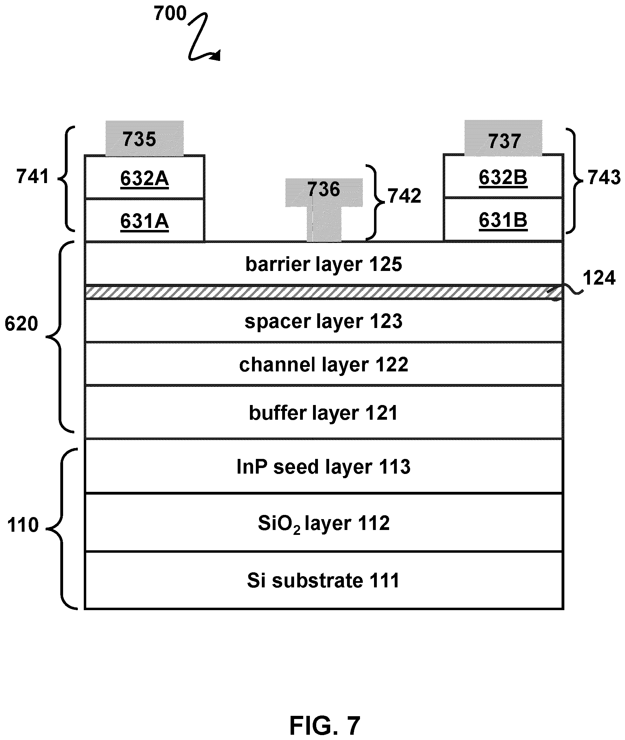

FIG. 7 is a schematic cross-sectional diagram of a HEMT according to an example.

FIG. 7 shows a later fabrication stage of the HEMT compared to the stage shown in the FIG. 6, in which the cap layer 632 and stop etch layer 631 of the layered semiconductor structure 600 have been etched such that two electrically isolated regions 631A and 631B of the stop etch layer 631 are formed and two electrically isolated regions 632A and 632B of the cap layer 632 are formed.

After etching, this HEMT 700 includes:
- a first structure 741, forming the source of the HEMT, including the first InGaAs region 632A,
- a second structure 743, forming the drain of the HEMT, including the second InGaAs region 632B; and
- a third structure 742 forming the gate of the HEMT.

The structures 741, 742, 743 are electrically isolated one with respect to the others.

Further metallic contacts 735, 736, 737 may be deposited to form the electric contacts of the HEMT for facilitating electrical connection of the HEMT.

In the example of FIG. 7, the first structure 741 forming the source of the HEMT comprises: a first metallic contact 735, the first InGaAs region 632A below the first metallic contact 735 and optionally, a InP stop etch region 631A below the first InGaAs region 632A.

Likewise, the second structure 743 forming the drain of the HEMT comprises: a second metallic contact 737, the second InGaAs region 632B below the second metallic contact 735 and optionally, a InP stop etch region 631B below the second InGaAs region 632B.

The third structure 742 may include a third metallic contact 736 forming the gate of the HEMT. The third metallic contact 736 may be positioned on (e.g., in contact with) the stack 620 of III-V layers (namely on the barrier layer 125) and between the first structure 741 and the second structure 743. The third metallic contact 736 is electrically isolated from the first structure 741 and the second structure 743.

In the layered semiconductor structure of the HEMT 700, InGaAs is the most conductive material, offering high mobility for electrons and low resistivity. When the source and drain are correctly polarised, a current flows from the source to the drain. The current passes through all the layers. The electrons fall into the layer with the highest mobility, i.e. InGaAs channel 122 and move from source to drain (i.e., from left to the right in FIG. 7) and are collected by the drain: the current flows. The other layers (buffer layer 121, spacer layer 123, barrier layer 125) are there to confine the InGaAs channel layer 122 and form barriers on either side to force the electrons to stay in the InGaAs channel layer 122.

To cut off the current, the gate is electrically biased. This has the effect to deplete the entire area on the gate, and the electrons (i.e., the current) will no longer be able to pass through the channel layer 122. Polarising the gate therefore closes the transistor and opening the gate charges the transistor again.

The greater the electron mobility, the faster the gate can be operated and the faster the transistor can be opened and closed. And, therefore, this increases the frequency at which the transistor is used.

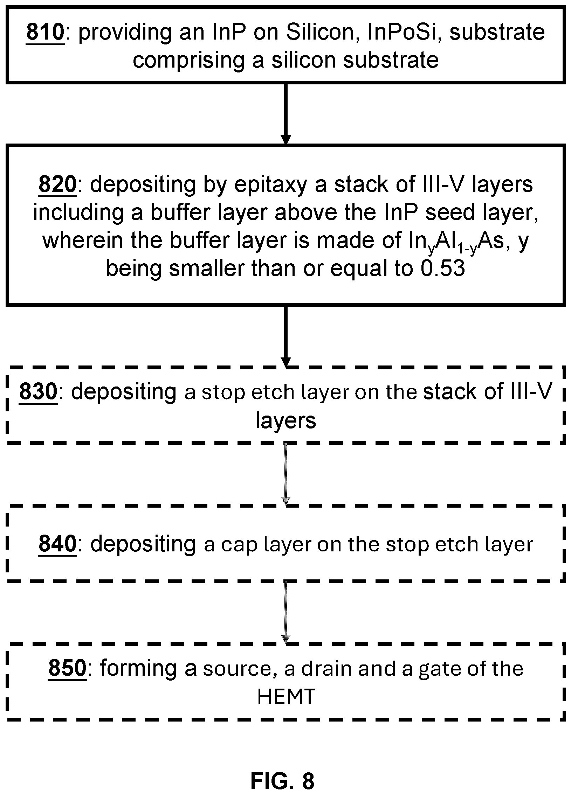

FIG. 8 is a flow chart of a method for fabricating a layered semiconductor structure.

At step 810, an InPoSi substrate 110 is provided. The InPoSi substrate 110 comprises a silicon substrate, a silica layer on the silicon substrate and an InP seed layer on the silica layer.

At step 820, a stack of III-V layers, including a buffer layer above or on the InP seed layer, is deposited by epitaxy on the InPoSi substrate 110. This can take place at approximately 500°C or approximately between 500°C and 700°C. The heat causes the materials of the InPoSi substrate to expand. InP layer and SiO₂ do not expand in the same way. In epitaxy, the stack of III-V layers is deposited on the InP layer under slight tension, its mesh being deformed. As the materials cool, the InPoSi substrate shrinks and recontracts.

The buffer layer is made of In_{y}Al_{1-y}As, y being smaller than or equal to 0.53. The stack of III-V layers may be any stack of III-V layers described herein. This allows to compensate for the stress during epitaxy with a slightly tensioned buffer layer.

Optionally, steps 830 to 850 may be performed to fabricate a HEMT.

At step 830, a stop etch layer 631 may be deposited on the stack of III-V layers.

At step 840, a cap layer 632 may be deposited on the stop etch layer 631.

At step 850, in step 850, the source, drain and gate of the HEMT are formed by etching the cap layer 632 and stop etch layer 631.

Although the foregoing description has been set out with reference to particular examples, it is to be understood that these examples are merely illustrative of the principles and applications of the present disclosure. It is therefore to be understood that numerous modifications can be made to the illustrative examples and that other arrangements can be devised without departing from the spirit and scope of the disclosure as determined based upon the claims and any equivalents thereof.

### LIST OF MAIN ABBREVIATIONS

- Al: Aluminium
- As: Arsenic
- CTE: Coefficient of Thermal Expansion
- Ga: Gallium
- HEMT: high-electron-mobility transistor
- In: Indium
- InPoSi: InP on Silicon
- SiO₂: Silicate
- SOI: silicon on insulator

## Claims

1. A layered semiconductor structure comprising:
an InP on Silicon, InPoSi, substrate, wherein the InPoSi substrate comprises:
a silicon substrate;
a silica layer on the silicon substrate; and
an InP seed layer on the silica layer;
a stack of III-V layers on the InPoSi substrate,
wherein the stack of III-V layers comprises a buffer layer above the InP seed layer;
wherein the buffer layer is made of In_{y}Al_{1-y}As, y being smaller than or equal to 0.53.

2. The layered semiconductor structure of claim 1, wherein y is larger than 0.47.

3. The layered semiconductor structure of any preceding claim, wherein the buffer layer has a thickness smaller than or equal to 500 nm.

4. The layered semiconductor structure of any preceding claim, wherein the buffer layer is a grown layer on the InP seed layer.

5. The layered semiconductor structure of any preceding claim, wherein the InP seed layer is a bonded layer on the silica layer.

6. The layered semiconductor structure of any preceding claim, comprising two superimposed buffer layers in contact with each other, the lower of the two superimposed buffer layers being the buffer layer on the InP seed layer, wherein the upper of the buffer layers is thinner than the lower buffer layer and has a thickness smaller than 50 nm, wherein the upper buffer layer is made of In_{z}Al_{1-z}As, z being smaller than or equal to 0.53 and larger than 0.47, wherein z is smaller than y.

7. The layered semiconductor structure of any preceding claim, wherein the stack of III-V layers comprises:
at least one channel layer above the at least one buffer layer, wherein the at least one channel layer is made of InₓGa₁₋ₓAs, wherein x is larger than or equal to 0.53.

8. The layered semiconductor structure of claim 7, wherein the stack of III-V layers further comprises:
a spacer layer made of InₛAl₁₋ₛAs, wherein the spacer layer is next to at least one channel layer;
a barrier layer made of In_{b}Al_{1-b}As, wherein the barrier layer is above the spacer layer.

9. The layered semiconductor structure of any preceding claim, wherein the stack of III-V layers comprises at least one n-type delta doped interface layer between the spacer layer and the barrier layer.

10. The layered semiconductor structure of any of claims 8 to 9, wherein b is smaller than or equal to 0.53, wherein b is larger than 0.47.

11. The layered semiconductor structure of any one of claims 8 to 10, wherein s is smaller than or equal to 0.53, wherein s is larger than 0.47.

12. The layered semiconductor structure of any one of claims 8 to 11, wherein the at least one channel layer has a thickness smaller than or equal to 30 nm, wherein the spacer layer has a thickness smaller than or equal to 10 nm, wherein the barrier layer has a thickness smaller than or equal to 40 nm.

13. A high electron mobility transistor, HEMT, structure comprising at least one layered semiconductor structure according to any one of claims 1 to 12.

14. The HEMT structure of claim 13, wherein the HEMT structure comprises
- a source comprising a first InGaAs region above the stack of III-V layers;
- a drain comprising a second InGaAs region above the stack of III-V layers,;
- a gate positioned above the stack of III-V layers, between the first and second InGaAs regions and electrically isolated from the first and second InGaAs regions.

15. A method of fabricating a layered semiconductor structure, the method comprising:
providing an InP on Silicon, InPoSi, substrate comprising a silicon substrate, a silica layer on the silicon substrate and an InP seed layer on the silica layer;
depositing by epitaxy a stack of III-V layers including a buffer layer above the InP seed layer;
wherein the buffer layer is made of In_{y}Al_{1-y}As, y being smaller than or equal to 0.53.
